# EUROPÄISCHE PATENTSCHRIFT

(11) **EP 3 017 017 B1**
(45) Veröffentlichungstag und Bekanntmachung des Hinweises auf die Patenterteilung: **15.03.2017**
(21) Anmeldenummer: 14772076.7
(22) Anmeldetag: 26.08.2014
(51) Int. Cl.: H01L 33/50, C09K 11/78, C09K 11/86, C09K 11/77

(54) **VERBESSERTER GRANATLEUCHTSTOFF UND VERFAHREN ZU DESSEN HERSTELLUNG SOWIE LICHTQUELLE**
IMPROVED GARNET LUMINOPHORE AND PROCESS FOR PRODUCTION THEREOF AND LIGHT SOURCE
SUBSTANCE LUMINESCENTE AMÉLIORÉE À BASE DE GRENAT, PROCÉDÉ POUR LA PRÉPARER AINSI QUE SOURCE LUMINEUSE

(30) Priorität: 28.08.2013 DE 102013109313
(43) Veröffentlichungstag der Anmeldung: 11.05.2016
(73) Patentinhaber: Leuchtstoffwerk Breitungen GmbH, 98597 Breitungen (DE)
(72) Erfinder: LIMBURG, Hans-Jürgen, 36469 Tiefenort (DE)
(74) Vertreter: Engel, Christoph Klaus
(86) Internationale Anmeldenummer: PCT/EP2014/068034
(87) Internationale Veröffentlichungsnummer: WO 2015/028447

(56) Entgegenhaltungen:
- CN-A- 1 733 865
- CN-A- 101 760 197
- CN-A- 102 173 773

## Beschreibung

Die vorliegende Erfindung betrifft einen verbesserten Granatleuchtstoff, welcher durch elektromagnetische Strahlung in einem ersten Wellenlängenbereich anregbar ist, wodurch elektromagnetische Strahlung in einem zweiten Wellenlängenbereich vom Granatleuchtstoff emittierbar ist. Die Erfindung betrifft im Weiteren ein Verfahren zum Herstellen eines verbesserten Granatleuchtstoffes sowie eine Lichtquelle, welche den erfindungsgemäßen Granatleuchtstoff umfasst.

Die WO 87/02374 A1 zeigt Granatleuchtstoffpartikel der Formel Y₃Al₅O₁₂, die mit einem Sulfat gebunden sind.

Die JP 10242513 A zeigt Granatleuchtstoffe der allgemeinen chemischen Formeln (RE₁₋ₓSmₓ)₃(Al_{y}Ga_{1-y})₅O₁₂:Ce und (YᵣGd₁₋ᵣ)₃Al₅O₁₂:Ce.

Die WO 2012/009455 A1 zeigt modifizierte Granatleuchtstoffe der allgemeinen chemischen Formel:

(Lu_{1-a-b-c}YₐTb_{1-b}A_{c})₃(Al_{1-d}B_{d})₅(O₁₋ₑCₑ)₁₂:Ce, Eu

mit A = Mg, Sr, Ca, Ba; B = Ga, In; C = F, CI, Br;
sowie:

(Y, A)₃(Al,B)₅(O,C)₁₂:Ce

mit A = Tb, Gd, Sm, La, Lu, Sr, Ca, Mg; B = Si, Ge, B, P, Ga.

Die US 5,988,925 zeigt Granatleuchtstoffe der allgemeinen chemischen Formel:

(RE₁₋ᵣSmᵣ)₃(Al₁₋ₛGaₛ)₅O₁₂:Ce

mit RE = Y, Gd.

Die WO 01/08453 A1 lehrt Granatleuchtstoffe der allgemeinen chemischen Formel:

(Tb_{1-x-y}SEₓCe_{y})₃(Al, Ga)₅O₁₂

mit SE = Y, Gd, La, Sm, Lu.

Der Einbau von Tb soll der Verschiebung der Emissionswellenlänge dienen, um insbesondere Leuchtstoffe für weiße LED bereitstellen zu können.

Die EP 2 253 689 A2 zeigt Leuchtstoffe der allgemeinen chemischen Formel:

a (M¹O)·b(M²₂O)·c (M²X)·dAl₂O_{3·}e(M³O)·f(M⁴₂O₃)·g(M⁵ₒOₚ)·h(M⁶ₓO_{y})

mit M¹ = Cu, Pb; M² = Li, Na, K, Rb, Cs, Au, Ag;
M³ = Be, Mg, Ca, Sr, Ba, Zn, Cd, Mn;
M⁴ = Sc, B, Ga, In; M⁵ = Si, Ge, Ti, Zr, Mn, V, Nb, Ta, W, Mo; M⁶ = Bi, Sn, Sb, Sc, Y, La, Ce, Pr, Nd, Pm, Sm, Eu, Gd, Tb, Dy, Ho, Er, Tm, Yb, Lu.
Als konkrete Beispiele sind u. a. Cu_{0,2}Mg_{1,7}Li_{0,2}Sb₂O₇:Mn und Cu_{0,02}Ca_{4,98} (PO₄) ₃Cl:Eu angegeben. Der Platzhalter M⁶ steht für den Aktivator, welcher beispielsweise Y, Ce, Eu oder Gd sein kann. Das Wirtsgitter kann M¹, M², M³, M⁴ und M⁵ umfassen, wobei diese Platzhalter u. a. nicht für Lu, Y und Gd stehen.

Aus der US 2005/0093442 A1 sind Granatleuchtstoffe der folgenden allgemeinen chemischen Formel bekannt:

(Tb_{1-x-y-z-w}YₓGd_{y}Lu_{z}Ce_{w})₃MᵣAl₅₋ᵣO_{12+δ}

mit M = Sc, In, Ga, Zn, Mg.

Die US 2004/0173807 A1 zeigt Granatleuchtstoffe der allgemeinen chemischen Formel:

RE₃ (Al₁₋ₛGaₛ)₅O₁₂:Ce:xMAl₂O₄

mit RE = Y, Gd, Sm, Lu, Yb; und M als ein Alkalimetall oder Erdalkalimetall. Die Variable x reicht von 0,01 bis 1,0%. Konkrete Beispiele für den Leuchtstoff sind in dieser Druckschrift nicht gezeigt. Als einziges Beispiel für M ist Ba angegeben, sodass eine geringe Menge BaAl₂O₄ im Leuchtstoff dotiert ist.

Die US 2007/0273282 A1 betrifft insbesondere eine weiß leuchtende LED. Für die Erzeugung des weißen Lichts sind unterschiedlichste Konversionsleuchtstoffe angegeben, u. a. Sr₂P₂O₇:Eu²⁺,Mn²⁺ und Be₂P₂O₇:Eu²⁺,Mn²⁺, bei denen es sich um Erdalkalimetalldiphosphate handelt.

Die CN 1 733 865 A zeigt einen Leuchtstoff der Formel Y₃Al₅O₁₂:Ce,Li, der auch als Y_{2,95}Ce_{0,01}Li_{0,04}Al₅O₁₂ angegeben ist.

In der CN 102 173 773 A ist ein Ce, Li kodotierter YAG-Leuchtstoff angegeben, der auch als Y_{2,95}Ce_{0,01}Li_{0,04}Al₅O₁₂ benannt ist.

Die CN 101 760 197 A zeigt u. a. einen Leuchtstoff der Formel Y_{2,94}Al₅ (0,F) ₁₂: 0,06Ce und einen Leuchtstoff der Formel Y_{2,92}Al_{4,8}Li_{0,1}V_{0,1}(O,F)₁₂:0,08Ce. Es wird darauf hingewiesen, dass die Einfügung von Ti, Zr, V, Mn, Zn, Mg oder Li in einen YAG-Leuchtstoff zur Emission in anderen Wellenlängenbereichen führt.

Die Aufgabe der vorliegenden Erfindung besteht ausgehend vom Stand der Technik darin, einen modifizierten und verbesserten Granatleuchtstoff bereitzustellen, dessen Emissionswellenlänge sich in Abhängigkeit von der Konzentration der Bestandteile des Granatleuchtstoffes über einen großen Bereich hinweg verändert. Im Weiteren sind ein Verfahren zur Herstellung eines verbesserten Granatleuchtstoffes sowie eine Lichtquelle mit einem verbesserten Granatleuchtstoff bereitzustellen.

Die genannte Aufgabe wird gelöst durch einen Granatleuchtstoff gemäß dem beigefügten Anspruch 1 und durch einen Granatleuchtstoff gemäß dem beigefügten unabhängigen Anspruch 3. Die Aufgabe wird weiterhin gelöst durch ein Verfahren zum Herstellen eines verbesserten Granatleuchtstoffes gemäß dem beigefügten nebengeordneten Anspruch 8 sowie durch eine Lichtquelle gemäß dem beigefügten nebengeordneten Anspruch 9.

Bei dem erfindungsgemäßen Granatleuchtstoff handelt es sich um einen Konversionsleuchtstoff. Folglich ist der Granatleuchtstoff durch elektromagnetische Strahlung in einem ersten Wellenlängenbereich anregbar. Bei der elektromagnetischen Strahlung im ersten Wellenlängenbereich kann es sich insbesondere um Licht oder um UV-Strahlung handeln. Infolge der Anregung ist eine elektromagnetische Strahlung in einem zweiten Wellenlängenbereich vom Granatleuchtstoff emittierbar. Bei der elektromagnetischen Strahlung im zweiten Wellenlängenbereich kann sich insbesondere um Licht oder IR-Strahlung handeln. Der erste Wellenlängenbereich ist bevorzugt verschieden vom zweiten Wellenlängenbereich.

Der Granatleuchtstoff ist mit dreiwertigem Cer aktiviert. Hierfür ist das Cer in geringen Mengen in ein Wirtsgitter des Granatleuchtstoffes dotiert. In das Wirtsgitter des Granatleuchtstoffes können auch weitere Ionen als Koaktivatoren dotiert sein.

Das Wirtsgitter des Granatleuchtstoffes weist die folgende allgemeine chemische Formel auf:

(LuₓY_{y}Gd_{z}AKₖ)₃(Al_{b}B_{c}P_{d})₅(OₑX_{f})₁₂

In dieser Formel steht AK für ein oder mehrere Alkalimetalle, ausgewählt aus der die Elemente Li, Na und K umfassenden Gruppe. Der Platzhalter B steht für Ga, In oder eine Mischung dieser Elemente. Der Platzhalter X steht für ein oder mehrere Halogene, ausgewählt aus der die Elemente F, Cl und Br umfassenden Gruppe.

Die Variablen x, y und z sind jeweils größer oder gleich Null und kleiner als Eins. Die Variable k ist größer als Null, sodass grundsätzlich das Alkalimetall im Leuchtstoff enthalten ist. Die Variable k ist kleiner als Eins. Die Summe der Variablen x, y, z und k beträgt Eins. Die Variablen b und c sind jeweils größer oder gleich Null und kleiner oder gleich Eins. Die Summe der Variablen b und c ist größer als Null und bevorzugt größer als 0,5. Die Variable d ist größer oder gleich Null und kleiner als Eins. Die Summe der Variablen b, c und d ist kleiner oder gleich Eins. Die Variable e ist größer als Null und kleiner oder gleich Eins. Die Variable e ist bevorzugt größer als 0,5. Die Variable f ist größer oder gleich Null und kleiner als Eins. Die Summe der Variablen e und f ist kleiner oder gleich Eins.

Der erfindungsgemäße Granatleuchtstoff zeichnet sich dadurch aus, dass ein oder mehrere einwertige Alkalimetalle Li, Na und K in das Wirtsgitter eingebaut sind. Durch die Wahl des eingebauten Alkalimetalls und durch die Wahl dessen Anteiles k ist die Wellenlänge der Emission des erfindungsgemäßen Granatleuchtstoffes beeinflussbar. Der Einbau von Li als Alkalimetall führt wegen des kleineren Ionenradius von Li zu einer Grünverschiebung der Emission, während der Einbau von Na und/oder K als Alkalimetall in Abhängigkeit vom Ionenradius des jeweiligen Alkalimetalls eine Rotverschiebung ermöglicht. Die jeweilige Verschiebung nimmt mit dem Anteil k des Alkalimetalls jeweils über einen relevanten Bereich hinweg zu.

Auf dem Gebiet der Leuchtstofftechnik haben sich unterschiedliche Nomenklaturen zur Darstellung von Leuchtstoffen etabliert. Bei vereinfachten Formeldarstellungen wird die Konzentration des Aktivators nicht quantitativ angegeben, sodass sie auch beim Index des reduzierten Anteiles des regulären Gitterbestandteils nicht berücksichtigt wird. Gemäß einer solchen vereinfachten Nomenklatur kann der erfindungsgemäße Granatleuchtstoff wie folgt angegeben werden:

(LuₓY_{y}Gd_{z}AKₖ)₃(Al_{b}B_{c}P_{d})₅(OₑX_{f})₁₂:Ce

Die Platzhalter AK, B und X stehen für dieselben Elemente wie bei der oben angegebenen Formel für das Wirtsgitter. Die Variablen x, y, z, k, b, c, d, e und f weisen die gleichen Wertebereiche wie bei der oben angegebenen Formel für das Wirtsgitter auf.

Bei einer genaueren Nomenklatur zur Darstellung von Leuchtstoffen wird der Anteil des Aktivators quantitativ berücksichtigt. Gemäß einer solchen Nomenklatur kann der erfindungsgemäße Granatleuchtstoff wie folgt angegeben werden:

(Lu_{x'}Y_{y'}Gd_{z'}AK_{k'})₃(Al_{b}B_{c}P_{d})₅(OₑX_{f})₁₂:Ceₐ

Die Platzhalter AK, B und X stehen für dieselben Elemente wie bei der oben angegebenen Formel für das Wirtsgitter. Die Variablen b, c, d, e und f weisen die gleichen Wertebereiche wie bei der oben angegebenen Formel für das Wirtsgitter auf. Die Variablen x', y' und z' sind jeweils größer oder gleich Null und kleiner oder gleich (1 - a - k'), wobei k' größer als Null und kleiner als (1 - a) ist. Die Summe der Variablen x', y', z' und k' beträgt (1 - a).

Der Anteil des Aktivators Cer ist grundsätzlich größer als Null. Dieser Anteil ist bevorzugt kleiner oder gleich 0,4. In Bezug auf die oben angegebene Formel des erfindungsgemäßen Granatleuchtstoffes mit der Variable a für den Anteil von Cer gilt entsprechend, dass die Variable a größer als Null und bevorzugt kleiner oder gleich 0,4 ist. Weiter bevorzugt beträgt der Anteil des Aktivators Cer zwischen 0,005 und 0,15.

Der erfindungsgemäße Granatleuchtstoff kann auch geringe Anteile weiterer chemischer Elemente enthalten, solange diese die Emission, welche erfindungsgemäß durch das Cer in dem angegebenen Wirtsgitter bedingt ist, nicht verhindern, sondern allenfalls nur geringfügig beeinflussen.

Bei einer ersten Gruppe bevorzugter Ausführungsformen des erfindungsgemäßen Granatleuchtstoffes ist das Halogen X im Wirtsgitter enthalten. Dabei umfasst das Wirtsgitter kein Phosphor, sodass die Variable d gleich Null ist und die Summe der Variablen b und c gleich Eins beträgt. Die Variable f beträgt ein Viertel der Variablen k. Die Variable e beträgt Eins minus drei Achteln der Variablen k. Die resultierende allgemeine chemische Formel des Wirtsgitters ist:

(LuₓY_{y}Gd_{z}AKₖ)₃(Al_{b}B_{1-b})₅(O_{1-(3/8)·k}X_{k/4})₁₂.

Bei einer zweiten Gruppe bevorzugter Ausführungsformen des erfindungsgemäßen Granatleuchtstoffes ist Phosphor im Wirtsgitter enthalten. Dabei umfasst das Wirtsgitter kein Halogen X, sodass die Variable f gleich Null ist und die Variable e gleich Eins ist. Die Variable d beträgt ein Drittel der Variablen k. Die Variable b beträgt Eins minus der Variablen c und minus sieben Fünfundvierzigstel der Variablen k. Die resultierende allgemeine chemische Formel des Wirtsgitters ist:

(LuₓY_{y}Gd_{z}AKₖ)₃(Al_{1-c-(7/45)·k}B_{c}P_{k/3})₅O₁₂.

Grundsätzlich kann AK durch eines der Alkalimetalle Li, Na und K gebildet sein, wofür nachfolgend mehrere Beispiele angegeben sind:

(Lu_{0,9}Li_{0,1})₃Al₅(D_{0,9625}F_{0,025})₁₂:Ce

(Y_{0,95}Na₀,₀₅)₃Al₅(O_{0,98125}F_{0,0125})₁₂:Ce

(Y_{0,99}K_{0,01})₃Al₅(O_{0,9625}F_{0,0025})₁₂:Ce

Das Alkalimetall AK kann auch durch mehrere der Alkalimetalle Li, Na oder K gebildet sein. Weiter bevorzugt ist das Alkalimetall entweder durch Li, durch Na oder durch K gebildet. Diese Alkalimetalle eignen sich besonders gut für den Einbau in das Granatwirtsgitter.

Bei besonders bevorzugten Ausführungsformen ist das Alkalimetall durch Li gebildet, wodurch die Emissionswellenlänge des Granatleuchtstoffes verringert wird.

Bei weiteren besonders bevorzugten Ausführungsformen ist das Alkalimetall durch Na gebildet, wodurch die Emissionswellenlänge des Granatleuchtstoffes vergrößert wird.

Grundsätzlich kann X durch eines der Halogene F, Cl und Br gebildet sein, wofür nachfolgend mehrere Beispiele angegeben sind:

(Lu_{0,9}Li_{0,1})₃Al₅(O_{0,9625}F_{0,025})₁₂:Ce

(Y_{0,95}Na_{0,05})₃Al₅(O_{0,98125}Cl_{0,0125})₁₂:Ce

(Y_{0,99}Na_{0,01})₃Al₅(O_{0,99625}Br_{0,0025})₁₂:Ce

Das Halogen X kann durch F, Cl oder Br oder aus einer Mischung dieser Elemente gebildet sein. Bevorzugt ist das Halogen X entweder durch F, durch Cl oder durch Br gebildet.

Bei besonders bevorzugten Ausführungsformen ist das Halogen X durch F gebildet, wodurch die Synthese des Granatleuchtstoffes erleichtert ist.

Eine erste Gruppe bevorzugter Ausführungsformen umfasst von den Seltenerdmetallen Lu, Y und Gd ausschließlich Lu, sodass y = z = 0 und x = 1 - k, was zu der allgemeinen Formel (Lu₁₋ₖAKₖ)₃(Al_{b}B_{c}P_{d})₅(OₑX_{f})₁₂ des Wirtsgitters führt. Ein Beispiel für diesen Leuchtstoff ist (Lu_{0,9}Li_{0,1})₃Al₅(D_{0,9625}F_{0,025})₁₂:Ce. Bei dieser ersten Gruppe bevorzugter Ausführungsformen ist das Alkalimetall bevorzugt durch Li gebildet. Hierdurch ist eine Grünverschiebung der Emission bewirkt.

Eine zweite Gruppe bevorzugter Ausführungsformen umfasst von den Seltenerdmetallen Lu, Y und Gd ausschließlich Y, sodass x = z = 0 und y = 1 - k, was zu der allgemeinen Formel (Y₁₋ₖAKₖ)₃(Al_{b}B_{c}P_{d})₅(OₑX_{f})₁₂ des Wirtsgitters führt. Ein Beispiel für diesen Leuchtstoff ist (Y_{0,95}Na_{0,05})₃Al₅(O_{0,98125}F_{0,0125})₁₂:Ce. Bei dieser zweiten Gruppe bevorzugter Ausführungsformen ist das Alkalimetall bevorzugt durch Li gebildet. Hierdurch ist eine Grünverschiebung der Emission bewirkt. Alternativ ist bei dieser zweiten Gruppe bevorzugter Ausführungsformen das Alkalimetall bevorzugt durch Na gebildet. Hierdurch ist eine Orangeverschiebung der Emission bewirkt.

Eine dritte Gruppe bevorzugter Ausführungsformen umfasst von den Seltenerdmetallen Lu, Y und Gd ausschließlich Y und Gd, sodass x = 0 und y + z = 1 - k, was zu der allgemeinen Formel (Y_{y}Gd_{z}AKₖ)₃(Al_{b}B_{c}P_{d})₅(OₑX_{f})₁₂ des Wirtsgitters führt. Beispiele für diesen Leuchtstoff sind (Y_{0,45}Gd_{0,45}Na_{0,1})₃Al₅(O_{0,95}F_{0,05})₁₂:Ce und (Y_{0,45}Gd_{0,45}Na_{0,05})₃Al₅(O_{0,98125}Cl_{0,0125})₁₂:Ce. Bei dieser dritten Gruppe bevorzugter Ausführungsformen ist das Alkalimetall bevorzugt durch Na gebildet. Hierdurch ist eine Orangeverschiebung der Emission bewirkt.

Eine vierte Gruppe bevorzugter Ausführungsformen umfasst von den Seltenerdmetallen Lu, Y und Gd ausschließlich Lu und Gd, sodass y = 0 und x + z = 1 - k, was zu der allgemeinen Formel (LuₓGd_{z}AKₖ)₃(Al_{b}B_{c}P_{d})₅(OₑX_{f})₁₂ des Wirtsgitters führt. Ein Beispiel für diesen Leuchtstoff ist
(Lu_{0,75}Gd_{0,15}Li_{0,1})₃Al₅(O_{0,9625}F_{0,025})₁₂:Ce. Bei dieser vierten Gruppe bevorzugter Ausführungsformen ist das Alkalimetall bevorzugt durch Li gebildet.

Der Anteil k des Alkalimetalls beträgt bevorzugt zwischen 0,0025 und 0,2. Der Anteil f des Halogens X beträgt bevorzugt zwischen 0,000625 und 0,05.

Das im Wirtsgitter vorhandene Aluminium kann teilweise oder vollständig durch den Platzhalter B ersetzt sein. Der Ersatz des Al durch In und/oder Ga führt zur Verringerung der Emissionswellenlänge des Granatleuchtstoffes. Ein Beispiel hierfür ist:

(Lu_{0,9}Li_{0,1})₃(Al_{0,9}Ga_{0,1})₅(O_{0,9625}F_{0,025})₁₂:Ce

Bevorzugt wird das Al nur partiell durch B ersetzt, sodass c < 1, weiter bevorzugt c < 0,4. Bei alternativen bevorzugten Ausführungsformen ist das Al nicht durch B ersetzt, sodass c = 0.

Beispiele aus der zweiten Gruppe bevorzugter Ausführungsformen sind:

(Y_{0,9}Li_{0,1})₃(Al_{0,984}P_{0,033})₅O₁₂:Ce

(Lu_{0,9}Li_{0,1})₃(Al_{0,984}P_{0,033})₅O₁₂:Ce.

Der erste Wellenlängenbereich reicht bevorzugt von 250 nm bis 500 nm.

Eine mittlere Wellenlänge des ersten Wellenlängenbereiches, bei welcher die Anregung des Granatleuchtstoffes maximal ist, liegt bevorzugt im blauen Spektralbereich des Lichtspektrums.

Eine mittlere Wellenlänge des zweiten Wellenlängenbereiches, bei welcher die Emission des Granatleuchtstoffes maximal ist, liegt bevorzugt zwischen 480 nm und 630 nm, besonders bevorzugt zwischen 500 nm und 600 nm.

Das erfindungsgemäße Verfahren dient der Herstellung eines verbesserten Granatleuchtstoffes. Bei dem herzustellenden Granatleuchtstoff handelt es sich um einen Konversionsleuchtstoff. Folglich ist der herzustellende Granatleuchtstoff durch elektromagnetische Strahlung in einem ersten Wellenlängenbereich anregbar. Bei der elektromagnetischen Strahlung im ersten Wellenlängenbereich kann es sich insbesondere um Licht oder UV-Strahlung handeln. Infolge der Anregung ist eine elektromagnetische Strahlung in einem zweiten Wellenlängenbereich vom Granatleuchtstoff emittierbar. Bei der elektromagnetischen Strahlung im zweiten Wellenlängenbereich kann sich insbesondere Licht oder IR-Strahlung handeln.

Das erfindungsgemäße Verfahren umfasst zunächst einen Schritt, bei welchem mindestens eine chemische Verbindung bereitgestellt wird, die Lu, Y und/oder Gd umfasst. Weiterhin wird mindestens eine chemische Verbindung bereitgestellt, die Al, Ga und/oder In umfasst. Mindestens eine der genannten Verbindungen ist durch ein Oxid gebildet. Die genannten Verbindungen sind bevorzugt durch Oxalate, Carbonate, Halide und/oder Oxide gebildet. Besonders bevorzugt sind sämtliche Verbindungen durch Oxide gebildet.

In einem weiteren Schritt wird eine chemische Verbindung bereitgestellt, die Cer umfasst; bevorzugt Ceroxid oder Ceroxalat.

Weiterhin wird eine chemische Verbindung der allgemeinen chemischen Formel AKX bereitgestellt. Dabei steht der Platzhalter AK für ein oder mehrere Alkalimetalle, ausgewählt aus der die Elemente Li, Na und K umfassenden Gruppe. Der Platzhalter X steht für ein Halogen, welches aus der die Elemente F, Cl und Br umfassenden Gruppe ausgewählt ist, oder für ein Phosphat. Die chemische Verbindung AKX steht bei dem erfindungsgemäßen Verfahren in einer Doppelfunktion. Sie stellt einen Ausgangsstoff dar, dessen Bestandsteile im späteren Reaktionsprodukt, nämlich dem Granatleuchtstoff enthalten sind. Weiterhin wirkt AKX als ein Schmelzmittel.

In einem weiteren Schritt des erfindungsgemäßen Verfahrens werden die bereitgestellten chemischen Verbindungen vermahlen und zu einer Mischung vermischt. Die Mischung wird anschließend auf eine Temperatur von mehr als 1.400°C, bevorzugt mehr als 1.600°C erwärmt, wodurch die Bestandteile der Mischung zu einem Granatleuchtstoff reagieren. Das Erwärmen erfolgt bevorzugt unter einer reduzierenden Atmosphäre. Schließlich ist der Granatleuchtstoff abzukühlen.

Das erfindungsgemäße Verfahren dient bevorzugt der Herstellung des erfindungsgemäßen Leuchtstoffes. Besonders bevorzugt dient das erfindungsgemäße Verfahren der Herstellung bevorzugter Ausführungsformen des erfindungsgemäßen Leuchtstoffes.

Die erfindungsgemäße Lichtquelle umfasst den erfindungsgemäßen Granatleuchtstoff. Weiterhin umfasst die erfindungsgemäße Lichtquelle eine Strahlungsquelle zur Emission einer elektromagnetischen Strahlung im ersten Wellenlängenbereich. Bei der Strahlungsquelle handelt es sich bevorzugt um ein Halbleiterelement zur Wandlung elektrischer Energie in elektromagnetische Strahlung, insbesondere um einen elektrolumineszierenden Leuchtstoff, beispielsweise einen nitridischen Leuchtstoff. Durch die Strahlungsquelle ist bevorzugt Licht im blauen Spektralbereich des Lichtspektrums emittierbar. Demzufolge umfasst der erste Wellenlängenbereich bevorzugt den blauen Spektralbereich des Lichtspektrums. Die Strahlungsquelle und der Granatleuchtstoff sind in der Lichtquelle so angeordnet, dass die von der Strahlungsquelle emittierbare Strahlung auf den Granatleuchtstoff trifft, um diesen anregen zu können. Die Strahlungsquelle und der Granatleuchtstoff sind in der Lichtquelle bevorzugt so angeordnet, dass eine Mischung der von der Strahlungsquelle emittierbaren Strahlung und der vom Granatleuchtstoff emittierbaren Strahlung aus der Lichtquelle austreten kann. Bei der Mischung der von der Strahlungsquelle emittierbaren Strahlung und der vom Granatleuchtstoff emittierbaren Strahlung handelt es sich bevorzugt um weißes Licht.

Bei bevorzugten Ausführungsformen der erfindungsgemäßen Lichtquelle weist der zweite Wellenlängenbereich des Granatleuchtstoffes eine mittlere Wellenlänge im grünen, gelben oder orangenfarbenen Spektralbereich des Lichtspektrums auf. Besonders bevorzugt ist grünes Licht vom Granatleuchtstoff emittierbar. Die mittlere Wellenlänge ist bevorzugt kleiner als 550 nm, besonders bevorzugt kleiner als 530 nm. Die Lichtquelle umfasst weiterhin einen zweiten Konversionsleuchtstoff, der durch die von der Strahlungsquelle emittierbare Strahlung anregbar ist, wodurch elektromagnetische Strahlung im orangefarbenen und/oder roten Spektralbereich des Lichtspektrums vom zweiten Konversionsleuchtstoff emittierbar ist. Die Strahlung der Strahlungsquelle, bei der es sich bevorzugt um Licht im blauen Spektralbereich des Lichtspektrums handelt, die grüne Strahlung des Granatleuchtstoffes und die orangefarbene und/oder rote Strahlung des zweiten Konversionsleuchtstoffes ergeben in ihrer Mischung ein weißes Licht mit einem hohen Farbwiedergabeindex.

Bei einer alternativen bevorzugten Ausführungsform der erfindungsgemäßen Lichtquelle weist der zweite Wellenlängenbereich des Granatleuchtstoffes eine mittlere Wellenlänge im gelben Spektralbereich des Lichtspektrums auf, während es sich bei der Strahlung der Strahlungsquelle um Licht im blauen Spektralbereich des Lichtspektrums handelt. Bei dieser Ausführungsformen der erfindungsgemäßen Lichtquelle ist bevorzugt kein weiterer Konversionsleuchtstoff vorhanden.

Die erfindungsgemäße Lichtquelle ist bevorzugt durch eine LED oder durch eine LED-Hintergrundbeleuchtung für eine Flüssigkristallanzeige gebildet.

Weitere Vorteile, Einzelheiten und Weiterbildungen der Erfindung ergeben sich aus der nachfolgenden Beschreibung bevorzugter Ausführungsformen, unter Bezugnahme auf die Zeichnung. Es zeigen:
- Fig. 1:: Emissionsspektren von bevorzugten Ausführungsformen des erfindungsgemäßen Granatleuchtstoffes mit einem Wirtgitter der Zusammensetzung (Lu₁₋ₖLiₖ)₃Al₅(O_{1-(3/8)·k}F_{k/4})₁₂;
- Fig. 2:: Anregungsspektren der in Fig. 1 charakterisierten Ausführungsformen;
- Fig. 3:: weitere Anregungsspektren der in Fig. 1 charakterisierten Ausführungsformen;
- Fig. 4:: Emissionsspektren von bevorzugten Ausführungsformen des erfindungsgemäßen Granatleuchtstoffes mit einem Wirtgitter der Zusammensetzung (LuₓGd_{z}Liₖ)₃Al₅(O_{1-(3/8)·k}F_{k/4})₁₂;
- Fig. 5:: Anregungsspektren der in Fig. 4 charakterisierten Ausführungsformen;
- Fig. 6:: weitere Anregungsspektren der in Fig. 4 charakterisierten Ausführungsformen;
- Fig. 7:: Emissionsspektren von bevorzugten Ausführungsformen des erfindungsgemäßen Granatleuchtstoffes mit einem Wirtgitter der Zusammensetzung (Y₁₋ₖNaₖ)₃Al₅(O_{1-(3/8)·k}F_{k/4})₁₂; und
- Fig. 8:: Anregungsspektren der in Fig. 7 charakterisierten Ausführungsformen.

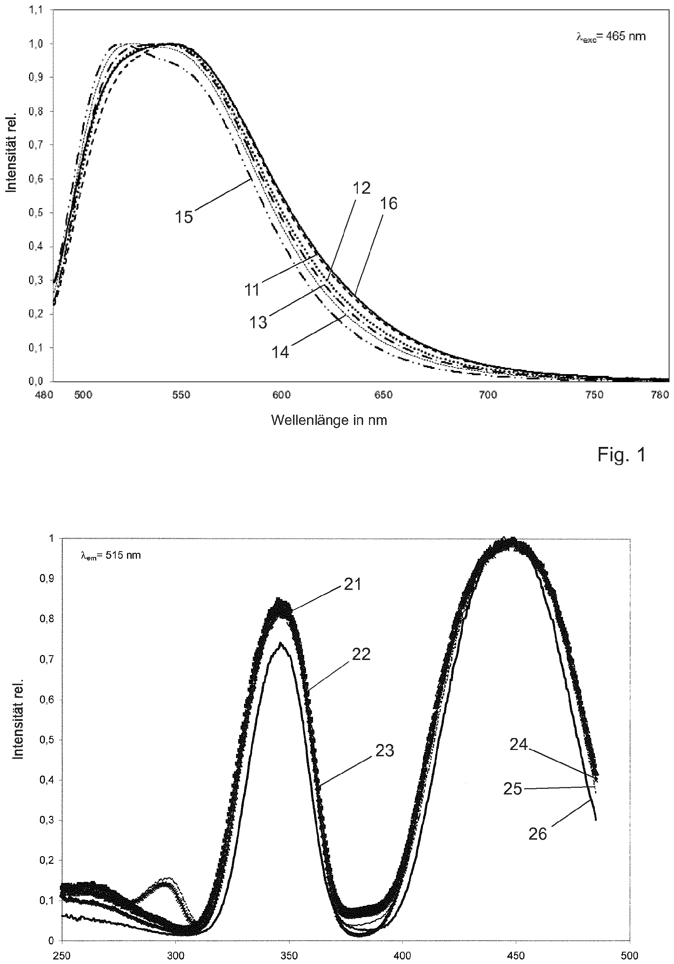

Fig. 1 bis Fig. 3 betreffen bevorzugte Ausführungsformen des erfindungsgemäßen Granatleuchtstoffes, welche ein Wirtgitter der allgemeinen chemischen Formel (Lu₁₋ₖLiₖ)₃Al₅(O_{1-(3/8)·k}F_{k/4})₁₂ aufweisen und mit Cer als Aktivator mit einem molaren Anteil von 0,014 dotiert sind.

Zur Herstellung dieser Ausführungsformen wurden unterschiedliche Mengen an Lu₂O₃, CeO₂, Al₂O₃ und LiF abgewogen und anschließend miteinander vermischt. Diese Mischungen wurden bei einer Temperatur von etwa 1.650°C geglüht, wodurch die Leuchtstoffe gebildet wurden. Bei dieser Reihe der Ausführungsformen wurde insbesondere der Anteil des LiF variiert. Die abgewogenen Mengen der Ausgangsstoffe sind in Tabelle 1Tabelle 3 aufgeführt.

**Tabelle 1**

| Lu₂O₃ in g | CeO₂ in g | Al₂O₃ in g | LiF in g | LiF in % | Σ in g |
|---|---|---|---|---|---|
| 141,253 | 1,735 | 61,177 | 1,021 | 0,50 | 205,185 |
| 139,291 | 1,711 | 60,327 | 2,517 | 1,25 | 203,846 |
| 137,329 | 1,687 | 59,477 | 4,962 | 2,50 | 203,456 |
| 135,367 | 1,663 | 58,628 | 9,783 | 5,00 | 205,441 |
| 129,482 | 1,590 | 56,079 | 18,715 | 10,0 | 205,866 |
| 141,253 | 1,735 | 61,177 | 0 | 0 | 204,165 |

Fig. 1 zeigt Emissionsspektren einer Reihe dieser Ausführungsformen, bei denen der Anteil des Li und des F variiert und zum Vergleich ein Emissionsspektrum einer Ausführungsform außerhalb der Erfindung, für deren Herstellung kein LiF in der Mischung enthalten war, jedoch im Übrigen der beschriebenen Mischung qualitativ glich. Die Anregung erfolgte mit einer Strahlung einer Wellenlänge von 465 nm. Die Zuordnung der verschiedenen Ausführungsformen mit unterschiedlichen LiF-Anteilen in der Mischung zu den mit Bezugsziffern gekennzeichneten Spektren ist in Tabelle 2 dargestellt.

Fig. 2 zeigt Anregungsspektren der beschriebenen Reihe von Ausführungsformen, bei denen der Anteil des Li und des F variiert. Diese Anregungsspektren sind bezogen auf eine Emissionswellenlänge von 515 nm. Die Zuordnung der verschiedenen Ausführungsformen zu den mit Bezugsziffern gekennzeichneten Spektren ist wiederum in Tabelle 2 dargestellt.

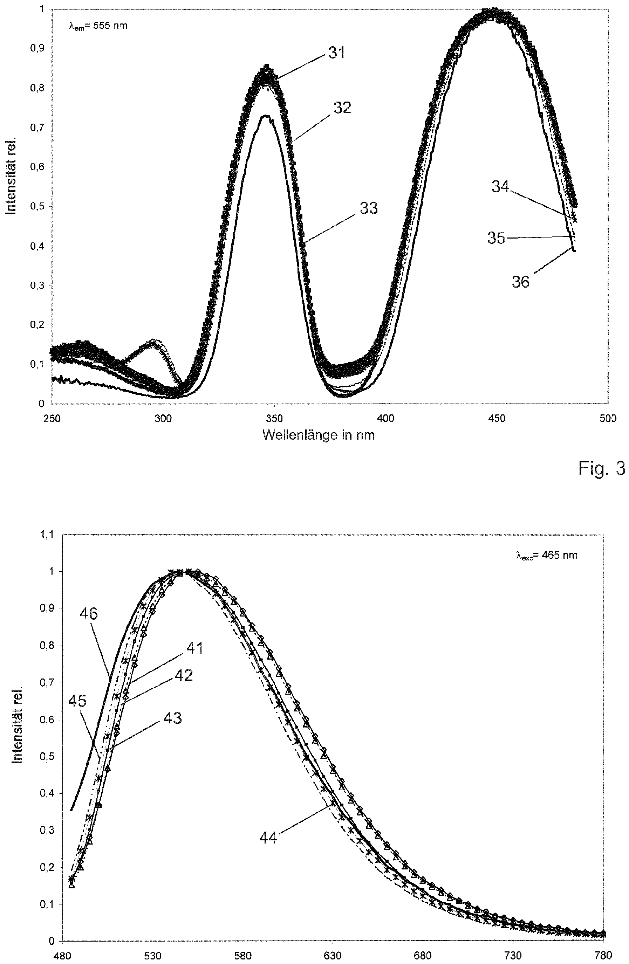

Fig. 3 zeigt weitere Anregungsspektren der beschriebenen Reihe von Ausführungsformen, bei denen der Anteil des Li und des F variiert. Diese weiteren Anregungsspektren sind bezogen auf eine Emissionswellenlänge von 555 nm. Die Zuordnung der verschiedenen Ausführungsformen zu den mit Bezugsziffern gekennzeichneten Spektren ist wiederum in Tabelle 2 dargestellt.

**Tabelle 2**

| Anteil von LiF in % | Bezugsziffer in Fig. 1 | Bezugsziffer in Fig. 2 | Bezugsziffer in Fig. 3 |
|---|---|---|---|
| 0,50 | 11 | 21 | 31 |
| 1,25 | 12 | 22 | 32 |
| 2,50 | 13 | 23 | 33 |
| 5,00 | 14 | 24 | 34 |
| 10,0 | 15 | 25 | 35 |
| 0 | 16 | 26 | 36 |

Fig. 4 bis Fig. 6 betreffen weitere bevorzugte Ausführungsformen des erfindungsgemäßen Granatleuchtstoffes, welche ein Wirtgitter der allgemeinen chemischen Formel (LuₓGd_{z}Liₖ)₃Al₅(O_{1-(3/8)·k}F_{k/4})₁₂ aufweisen und mit Cer als Aktivator mit einem molaren Anteil von 0,050 dotiert sind.
Zur Herstellung dieser Ausführungsformen wurden unterschiedliche Mengen an Gd₂O₃, CeO₂, Al₂O₃ und LiF abgewogen und anschließend miteinander vermischt. Daraufhin wurde jeweils eine Menge Lu₂O₃ abgewogen und mit der jeweiligen Mischung vermischt.
Diese Mischungen wurden bei einer Temperatur von etwa 1.650°C geglüht, wodurch die Leuchtstoffe gebildet wurden. Bei dieser Reihe der Ausführungsformen wurde wiederum insbesondere der Anteil des LiF variiert. Die abgewogenen Mengen der Ausgangsstoffe sind in Tabelle 3 aufgeführt.

**Tabelle 3**

| L_{U2}O₃ in g | Gd₂O₃ in g | CeO₂ in g | Al₂O₃ in g | LiF in g | LiF in % | Σ in g |
|---|---|---|---|---|---|---|
| 128,933 | 6,525 | 6,196 | 61,177 | 1,014 | 0,50 | 203,845 |
| 127,142 | 6,434 | 6,110 | 60,327 | 2,500 | 1,25 | 202,514 |
| 125,351 | 6,344 | 6,024 | 59,477 | 4,930 | 2,50 | 202,126 |
| 122,665 | 6,208 | 5,895 | 58,203 | 9,649 | 5,00 | 202,619 |
| 117,293 | 5,936 | 5,637 | 55,654 | 18,452 | 10,0 | 202,972 |
| 128,933 | 6,525 | 6,196 | 61,177 | 0 | 0 | 202,831 |

Fig. 4 zeigt Emissionsspektren dieser Reihe der Ausführungsformen mit den variierenden Anteilen von Li und F sowie zum Vergleich ein Emissionsspektrum der Ausführungsform außerhalb der Erfindung, für deren Herstellung kein LiF in der Mischung enthalten war. Die Anregung erfolgte mit einer Strahlung einer Wellenlänge von 465 nm. Die Zuordnung der verschiedenen Ausführungsformen mit unterschiedlichen LiF-Anteilen in der Mischung zu den mit Bezugsziffern gekennzeichneten Spektren ist in Tabelle 4 dargestellt.

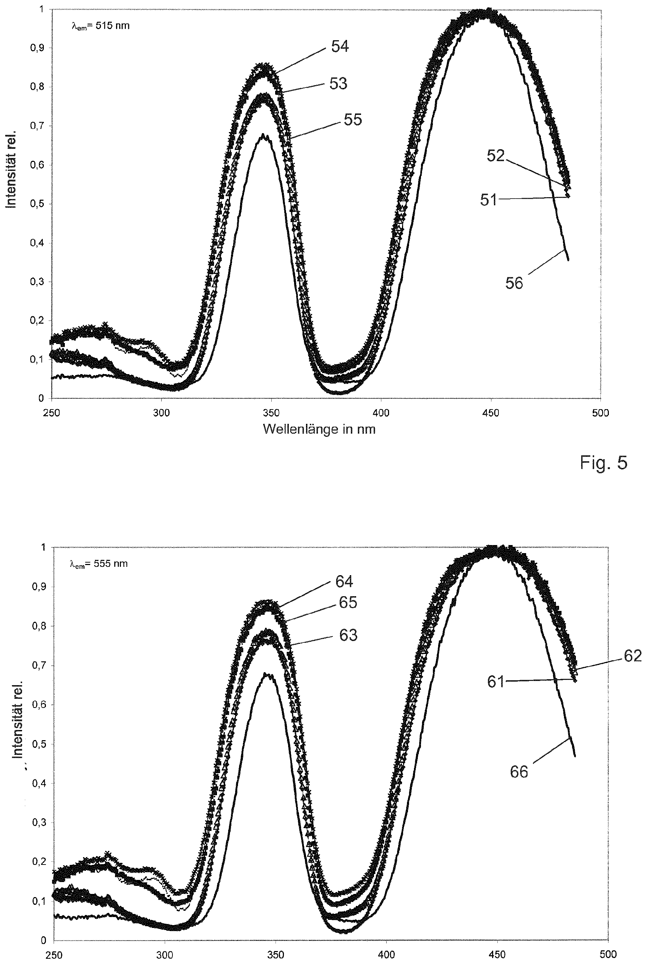

Fig. 5 zeigt Anregungsspektren der beschriebenen Reihe von Ausführungsformen, bei denen der Anteil des Li und des F variiert. Diese Anregungsspektren sind bezogen auf eine Emissionswellenlänge von 515 nm. Die Zuordnung der verschiedenen Ausführungsformen zu den mit Bezugsziffern gekennzeichneten Spektren ist wiederum in Tabelle 4 dargestellt.

Fig. 6 zeigt weitere Anregungsspektren der beschriebenen Reihe von Ausführungsformen, bei denen der Anteil des Li und des F variiert. Diese weiteren Anregungsspektren sind bezogen auf eine Emissionswellenlänge von 555 nm. Die Zuordnung der verschiedenen Ausführungsformen zu den mit Bezugsziffern gekennzeichneten Spektren ist wiederum in Tabelle 4 dargestellt.

**Tabelle 4**

| Anteil von LiF in % | Bezugsziffer in Fig. 4 | Bezugsziffer in Fig. 5 | Bezugsziffer in Fig. 6 |
|---|---|---|---|
| 0,50 | 41 | 51 | 61 |
| 1,25 | 42 | 52 | 62 |
| 2,50 | 43 | 53 | 63 |
| 5, 00 | 44 | 54 | 64 |
| 10,0 | 45 | 55 | 65 |
| 0 | 46 | 56 | 66 |

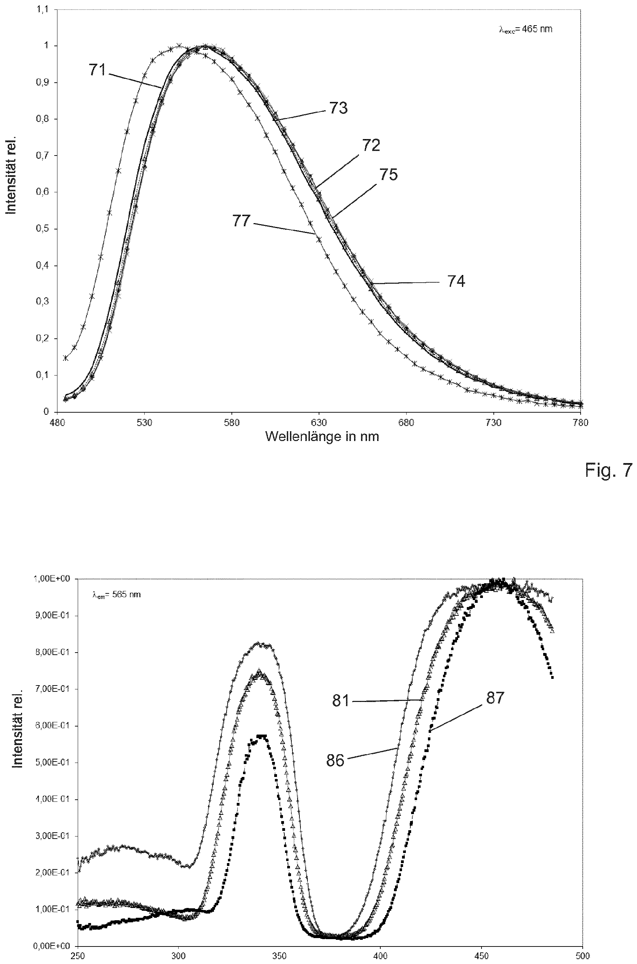

Fig. 7 und Fig. 8 betreffen weitere bevorzugte Ausführungsformen des erfindungsgemäßen Granatleuchtstoffes, welche ein Wirtgitter der allgemeinen chemischen Formel (Y₁₋ₖNaₖ)₃Al₅(O_{1-(3/8)·k}F_{k/4})₁₂ aufweisen und mit Cer als Aktivator mit einem molaren Anteil von 0,040 dotiert sind.

Zur Herstellung dieser Ausführungsformen wurden unterschiedliche Mengen CeO₂, Al₂O₃ und NaF abgewogen und anschließend miteinander vermischt. Daraufhin wurde jeweils eine Menge Y₂O₃ abgewogen und mit der jeweiligen Mischung vermischt. Diese Mischungen wurden in reduzierender Atmosphäre bei einer Temperatur von etwa 1.675°C geglüht, wodurch die Leuchtstoffe gebildet wurden. Bei dieser Reihe der Ausführungsformen wurde insbesondere der Anteil des NaF variiert. Die abgewogenen Mengen der Ausgangsstoffe sind in Tabelle 5 aufgeführt.

**Tabelle 5**

| Y₂O₃ in g | CeO₂ in g | Al₂O₃ in g | NaF in g | NaF in % | Σ in g |
|---|---|---|---|---|---|
| 217,861 | 13,838 | 170,785 | 1,006 | 0,25 | 403,491 |
| 216,778 | 13,770 | 169,936 | 2,002 | 0,50 | 402,485 |
| 216,778 | 13,770 | 169,936 | 3,004 | 0,75 | 403,486 |
| 215,694 | 13,701 | 169,086 | 3,985 | 1,00 | 402,465 |
| 216,778 | 13,770 | 169,936 | 4,606 | 1,15 | 405,088 |
| 215,152 | 13,666 | 168,661 | 5,962 | 1,50 | 403,461 |
| 218,945 | 13,907 | 171,635 | 0 | 0 | 404,488 |

Fig. 7 zeigt Emissionsspektren dieser Reihe der Ausführungsformen mit den variierenden Anteilen von Na und F sowie zum Vergleich ein Emissionsspektrum der Ausführungsform außerhalb der Erfindung, für deren Herstellung kein NaF in der Mischung enthalten war. Die Anregung erfolgte mit einer Strahlung einer Wellenlänge von 465 nm. Die Zuordnung der verschiedenen Ausführungsformen zu den mit Bezugsziffern gekennzeichneten Spektren ist in Tabelle 6 dargestellt.

Fig. 8 zeigt Anregungsspektren der beschriebenen Reihe von Ausführungsformen, bei denen der Anteil des Na und des F variiert. Diese Anregungsspektren sind bezogen auf eine Emissionswellenlänge von 565 nm. Die Zuordnung der verschiedenen Ausführungsformen zu den mit Bezugsziffern gekennzeichneten Spektren ist wiederum in Tabelle 6 dargestellt.

**Tabelle 6**

| Anteil von NaF in % | Bezugsziffer in Fig. 7 | Bezugsziffer in Fig. 8 |
|---|---|---|
| 0,25 | 71 | 81 |
| 0,50 | 72 | - |
| 0,75 | 73 | - |
| 1,00 | 74 | - |
| 1,15 | 75 | - |
| 1,50 | - | 86 |
| 0 | 77 | 87 |

Weitere bevorzugte Ausführungsformen des erfindungsgemäßen Granatleuchtstoffes weisen ein Wirtgitter der allgemeinen chemischen Formel (Lu₁₋ₖLiₖ)₃(Al_{1-(7/45)·k}P_{k/3})₅O₁₂ auf und sind mit Cer als Aktivator mit einem molaren Anteil von 0,010 dotiert.

Zur Herstellung dieser Ausführungsformen wurden unterschiedliche Mengen CeO₂, Al₂O₃ und Li₃PO₄ abgewogen und anschließend miteinander vermischt. Daraufhin wurde jeweils eine Menge Lu₂O₃ abgewogen und mit der jeweiligen Mischung vermischt. Diese Mischungen wurden in reduzierender Atmosphäre bei einer Temperatur von etwa 1.650°C geglüht, wodurch die Leuchtstoffe gebildet wurden. Bei dieser Reihe der Ausführungsformen wurde insbesondere der Anteil des Li₃PO₄ variiert. Die abgewogenen Mengen der Ausgangsstoffe sind in Tabelle 7 aufgeführt.

**Tabelle 7**

| Lu₂O₃ in g | CeO₂ in g | Al₂O₃ in g | Li₃PO₄ in g | Li₃PO₄ in % |
|---|---|---|---|---|
| 354,565 | 3,098 | 152,942 | 10,212 | 2,00 |
| 354,565 | 3,098 | 152,942 | 20,424 | 4,00 |
| 354,565 | 3,098 | 152,942 | 35,742 | 7,00 |
| 354,565 | 3,098 | 152,942 | 51,060 | 10,00 |
| 354,565 | 3,098 | 152,942 | 61,273 | 12, 00 |

### Bezugszeichenliste

- 11: - Emissionsspektrum (Lu₁₋ₖLiₖ)₃Al₅(O_{1-(3/8)·k}F_{k/4})₁₂ - 0,5 % LiF
- 12: - Emissionsspektrum (Lu₁₋ₖLiₖ)₃Al₅(O_{1-(3/8)·k}F_{k/4})₁₂ - 1,25 % LiF
- 13: - Emissionsspektrum (Lu₁₋ₖLiₖ)₃Al₅(O_{1-(3/g)·k}F_{k/4})₁₂ - 2,5 % LiF
- 14: - Emissionsspektrum (Lu₁₋ₖLiₖ)₃Al₅(O_{1-(3/8)·k}F_{k/4})₁₂ - 5,0 % LiF
- 15: - Emissionsspektrum (Lu₁₋ₖLiₖ)₃Al₅(O_{1-(3/8)·k}F_{k/4})₁₂ - 10,0 % LiF
- 16: - Emissionsspektrum Lu₃Al₅O₁₂

- 21: - Anregungsspektrum (Lu₁₋ₖLiₖ)₃Al₅(O_{1-(3/s)·k}F_{k/4})₁₂ - 0,5 % LiF
- 22: - Anregungsspektrum (Lu₁₋ₖLiₖ)₃Al₅(O_{1-(3/8)·k}F_{k/4})₁₂ - 1,25 % LiF
- 23: - Anregungsspektrum (Lu₁₋ₖLiₖ)₃Al₅(O_{1-(3/8)·k}F_{k/4})₁₂ - 2,5 % LiF
- 24: - Anregungsspektrum (Lu₁₋ₖLiₖ)₃Al₅(O_{1-(3/8)·k}F_{k/4})₁₂ - 5,0 % LiF
- 25: - Anregungsspektrum (Lu₁₋ₖLiₖ)₃Al₅(O_{1-(3/8)·k}F_{k/4})₁₂ - 10,0 % LiF
- 26: - Anregungsspektrum Lu₃Al₅O₁₂

- 31: - Anregungsspektrum (Lu₁₋ₖLiₖ)₃Al₅(O_{1-(3/8)·k}F_{k/4})₁₂ - 0,5 % LiF
- 32: - Anregungsspektrum (Lu₁₋ₖLiₖ)₃Al₅(O_{1-(3/8)·k}F_{k/4})₁₂ - 1,25 % LiF
- 33: - Anregungsspektrum (Lu₁₋ₖLiₖ)₃Al₅(O_{1-(3/8)·k}F_{k/4})₁₂ - 2,5 % LiF
- 34: - Anregungsspektrum (Lu₁₋ₖLiₖ)₃Al₅(O_{1-(3/8)·k}F_{k/4})₁₂ - 5,0 % LiF
- 35: - Anregungsspektrum (Lu₁₋ₖLiₖ)₃Al₅(O_{1-(3/8)·k}F_{k/4})₁₂ - 10,0 % LiF
- 36: - Anregungsspektrum Lu₃Al₅O₁₂

- 41: - Emissionsspektrum (LuₓGd_{z}Liₖ)₃Al₅(O_{1-(3/8)·k}F_{k/4})₁₂ - 0,5 % LiF
- 42: - Emissionsspektrum (LuₓGd_{z}Liₖ)₃Al₅(O_{1-(3/8)·k}F_{k/4})₁₂ - 1,25 % LiF
- 43: - Emissionsspektrum (LuₓGd_{z}Liₖ)₃Al₅(O_{1-(3/8)·k}F_{k/4})₁₂ - 2,5 % LiF
- 44: - Emissionsspektrum (LuₓGd_{z}Liₖ)₃Al₅(O_{1-(3/8)·k}F_{k/4})₁₂ - 5,0 % LiF
- 45: - Emissionsspektrum (LuₓGd_{z}Liₖ)₃Al₅(O_{1-(3/8)·k}F_{k/4})₁₂ - 10,0 % LiF
- 46: - Emissionsspektrum (LuₓGd_{z})₃Al₅O₁₂

- 51: - Anregungsspektrum (LuₓGd_{z}Liₖ)₃Al₅(O_{1-(3/8)·k}F_{k/4})₁₂ - 0,5 % LiF
- 52: - Anregungsspektrum (LuₓGd_{z}Liₖ)₃Al₅(O_{1-(3/8)·k}F_{k/4})₁₂ - 1,25 % LiF
- 53: - Anregungsspektrum (LuₓGd_{z}Liₖ)₃Al₅(O_{1-(3/8)·k}F_{k/4})₁₂ - 2,5 % LiF
- 54: - Anregungsspektrum (LuₓGd_{z}Liₖ)₃Al₅(O_{1-(3/8)·k}F_{k/4})₁₂ - 5,0 % LiF
- 55: - Anregungsspektrum (LuₓGd_{z}Liₖ)₃Al₅(O_{1-(3/8)·k}F_{k/4})₁₂ - 10, % LiF
- 56: - Anregungsspektrum (LuₓGd_{z})₃Al₅O₁₂

- 61: - Anregungsspektrum (LuₓGd_{z}Liₖ)₃Al₅(O_{1-(3/8)·k}F_{k/4})₁₂ - 0,5 % LiF
- 62: - Anregungsspektrum (LuₓGd_{z}Liₖ)₃Al₅(O_{1-(3/8)·k}F_{k/4})₁₂ - 1,25 % LiF
- 63: - Anregungsspektrum (LuₓGd_{z}Liₖ)₃Al₅(O_{1-(3/8)·k}F_{k/4})₁₂ - 2,5 % LiF
- 64: - Anregungsspektrum (LuₓGd_{z}Liₖ)₃Al₅(O_{1-(3/8)·k}F_{k/4})₁₂ 5,0 % LiF
- 65: - Anregungsspektrum (LuₓGd_{z}Liₖ)₃Al₅(O_{1-(3/8)}·ₖF_{k/4})₁₂ - 10,0 % LiF
- 66: - Anregungsspektrum (LuₓGd_{z})₃Al₅O₁₂

- 71: - Emissionsspektrum (Y₁₋ₖNaₖ)₃Al₅(O_{1-(3/8)·k}F_{k/4})₁₂ - 0,25 % NaF
- 72: - Emissionsspektrum (Y₁₋ₖNaₖ)₃Al₅(O_{1-(3/8)·k}F_{k/4})₁₂ - 0,50 % NaF
- 73: - Emissionsspektrum (Y₁₋ₖNaₖ)₃Al₅(O_{1-(3/8)·k}F_{k/4})₁₂ - 0,75 % NaF
- 74: - Emissionsspektrum (Y₁₋ₖNaₖ)₃Al₅(O_{1-(3/8)·k}F_{k/4})₁₂ - 1,00 % NaF
- 75: - Emissionsspektrum (Y₁₋ₖNaₖ)₃Al₅(O_{1-(3/8)·k}F_{k/4})₁₂ - 1,15 % NaF
- 77: - Emissionsspektrum Y₃Al₅O₁₂

- 81: - Anregungsspektrum (Y₁₋ₖNaₖ)₃Al₅(O_{1-(3/8)·k}F_{k/4})₁₂ - 0,25 % NaF
- 86: - Anregungsspektrum (Y₁₋ₖNaₖ)₃Al₅(O_{1-(3/8)·k}F_{k/4})₁₂ - 1,50 % NaF
- 87: - Anregungsspektrum Y₃Al₅O₁₂

## Patentansprüche

1. Granatleuchtstoff, welcher durch elektromagnetische Strahlung in einem ersten Wellenlängenbereich anregbar ist, wodurch elektromagnetische Strahlung in einem zweiten Wellenlängenbereich vom Granatleuchtstoff emittierbar ist, wobei der Granatleuchtstoff mit dreiwertigem Cer aktiviert ist und ein Wirtsgitter der folgenden allgemeinen chemischen Formel aufweist:
(LuₓY_{y}Gd_{z}AKₖ)₃(Al_{b}B_{c}P_{d})₅(OₑX_{f})₁₂
mit:
• AK = ein oder mehrere Alkalimetalle, ausgewählt aus der die Elemente Li, Na und K umfassenden Gruppe;
• B = Ga und/oder In;
• X = ein oder mehrere Halogene, ausgewählt aus der die Elemente F, Cl und Br umfassenden Gruppe;
• 0 ≤ x, y, z < 1;
• x + y + z + k = 1;
• 0 < k < 1;
• 0 ≤ b ≤ 1;
• 0 ≤ c ≤ 1;
• 0 < b + c;
• 0 ≤ d ≤ 1;
• b + c + d ≤ 1;
• 0 < e ≤ 1;
• 0 < f < 1; und
• e + f ≤ 1.

2. Granatleuchtstoff nach Anspruch 1, **dadurch gekennzeichnet, dass**:
• d = 0;
• b + c = 1;
• f = k/4; und
• e = 1 - (3/8)·k;
resultierend in der folgenden allgemeinen chemischen Formel des Wirtsgitters:
(LuₓY_{y}Gd_{z}AKₖ)₃(Al_{b}B_{1-b})₅(O_{1-(3/8)·k}X_{k/4})₁₂.

3. Granatleuchtstoff, welcher durch elektromagnetische Strahlung in einem ersten Wellenlängenbereich anregbar ist, wodurch elektromagnetische Strahlung in einem zweiten Wellenlängenbereich vom Granatleuchtstoff emittierbar ist, wobei der Granatleuchtstoff mit dreiwertigem Cer aktiviert ist und ein Wirtsgitter der folgenden allgemeinen chemischen Formel aufweist:
(LuₓY_{y}Gd_{z}AKₖ)₃(Al_{b}B_{c}P_{d})₅(OₑX_{f})₁₂
mit:
• AK = ein oder mehrere Alkalimetalle, ausgewählt aus der die Elemente Li, Na und K umfassenden Gruppe;
• B = Ga und/oder In;
• X = ein oder mehrere Halogene, ausgewählt aus der die Elemente F, Cl und Br umfassenden Gruppe;
• 0 ≤ x, y, z < 1;
• x + y + z + k = 1;
• 0 < k < 1;
• 0 ≤ b ≤ 1;
• 0 ≤ c ≤ 1;
• 0 < b + c;
• 0 < d < 1;
• b + c + d ≤ 1;
• 0 < e < 1;
• 0 ≤ f < 1; und
• e + f ≤ 1.

4. Granatleuchtstoff nach Anspruch 3, **dadurch gekennzeichnet, dass**:
• e = 1;
• f = 0;
• d = k/3; und
• b = 1 - c - (7/45)·k;
resultierend in der folgenden allgemeinen chemischen Formel des Wirtsgitters:
(LuₓY_{y}Gd_{z}AKₖ)₃(Al_{1-c-(7/45)·k}B_{c}P_{k/3})₅O₁₂.

5. Granatleuchtstoff nach einem der Ansprüche 1 bis 4, **dadurch gekennzeichnet, dass** der Platzhalter AK für Li oder für Na steht.

6. Granatleuchtstoff nach Anspruch 2 oder dem auf Anspruch 2 rückbezogenen Anspruch 5, **dadurch gekennzeichnet, dass** der Platzhalter X für F steht.

7. Granatleuchtstoff nach einem der Ansprüche 1 bis 6, **dadurch gekennzeichnet, dass** eine mittlere Wellenlänge des zweiten Wellenlängenbereiches zwischen 500 nm und 600 nm beträgt.

8. Verfahren zur Herstellung eines Granatleuchtstoffes, folgende Schritte umfassend:
- Bereitstellen mindestens einer Lu, Y und/oder Gd umfassenden Verbindung und mindestens einer Al, Ga und/oder In umfassenden Verbindung, wobei mindestens eine der Verbindungen durch ein Oxid gebildet ist;
- Bereitstellen einer Ce umfassenden Verbindung;
- Bereitstellen einer Verbindung der allgemeinen chemischen Formel AKX, wobei AK für ein oder mehrere Alkalimetalle, ausgewählt aus der die Elemente Li, Na und K umfassenden Gruppe steht, und X für ein aus der die Elemente F, Cl und Br umfassenden Gruppe ausgewähltes Halogen oder für ein Phosphat steht;
- Vermahlen und Vermischen der bereitgestellten chemischen Verbindungen zu einer Mischung;
- Erwärmen der Mischung auf eine Temperatur von mehr als 1.400°C, wodurch die Mischung zu einem Granatleuchtstoff reagiert; und
- Abkühlen des Granatleuchtstoffes.

9. Lichtquelle mit einem Granatleuchtstoff nach einem der Ansprüche 1 bis 7 und mit einer Strahlungsquelle zur Emission einer elektromagnetischen Strahlung im ersten Wellenlängenbereich.

10. Lichtquelle nach Anspruch 9, **dadurch gekennzeichnet, dass** der zweite Wellenlängenbereich des Granatleuchtstoffes ein Maximum im grünen Spektralbereich des Lichtspektrums aufweist, und dass die Lichtquelle einen zweiten Konversionsleuchtstoff umfasst, der durch die von der Strahlungsquelle emittierbare Strahlung anregbar ist, wodurch elektromagnetische Strahlung im orangefarbenen und/oder roten Spektralbereich des Lichtspektrums vom zweiten Konversionsleuchtstoff emittierbar ist.

11. Lichtquelle nach Anspruch 9 oder 10, **dadurch gekennzeichnet, dass** sie durch eine LED oder durch eine LED-Hintergrundbeleuchtung für eine Flüssigkristallanzeige gebildet ist.

## Claims

1. Garnet luminophore which can be excited in a first wavelength range by electromagnetic radiation, as a result of which electromagnetic radiation can be emitted by the garnet luminophore in a second wavelength range, wherein said garnet luminophore is activated with trivalent cerium and has a host lattice of the following general chemical formula:
(LuₓY_{y}Gd_{z}AKₖ)₃(Al_{b}B_{c}P_{d})₅(OₑX_{f})₁₂
wherein:
• AK = one or several alkaline metals selected from the group including the elements Li, Na, and K;
• B = Ga and/or In;
• X = one or several halogens selected from the group including the elements F, Cl, and Br;
• 0 ≤ x, y, z < 1;
• x + y + z + k = 1;
• 0 < k < 1;
• 0 ≤ b ≤ 1;
• 0 ≤ c ≤ 1;
• 0 < b + c;
• 0 ≤ d < 1;
• b + c + d ≤ 1;
• 0 < e ≤ 1;
• 0 < f < 1; and
• e + f ≤ 1.

2. Garnet luminophore according to claim 1, **characterized in that**:
• d = 0;
• b + c = 1;
• f = k/4; and
• e = 1 - (3/8)·k;
resulting in the following general chemical formula of the host lattice:
(LuₓY_{y}Gd_{z}AKₖ)₃(Al_{b}B_{1-b})₅(O_{1-(3/8)·k}X_{k/4})₁₂.

3. Garnet luminophore, which can be excited in a first wavelength range by electromagnetic radiation, as a result of which electromagnetic radiation can be emitted by the garnet luminophore in a second wavelength range, wherein said garnet luminophore is activated with trivalent cerium and has a host lattice of the following general chemical formula:
(LuₓY_{y}Gd_{z}AKₖ)₃(Al_{b}B_{c}P_{d})₅(OₑX_{f})₁₂
wherein:
• AK = one or several alkaline metals selected from the group including the elements Li, Na, and K;
• B = Ga and/or In;
• X = one or several halogens selected from the group including the elements F, Cl, and Br;
• 0 ≤ x, y, z < 1;
• x + y + z + k = 1;
• 0 < k < 1;
• 0 ≤ b ≤ 1;
• 0 ≤ c ≤ 1;
• 0 < b + c;
• 0 < d < 1;
• b + c + d ≤ 1;
• 0 < e ≤ 1;
• 0 ≤ f < 1; and
• e + f ≤ 1.

4. Garnet luminophore according to claim 3, **characterized in that**:
• e = 1;
• f = 0;
• d = k/3; and
• b = 1 - c - (7/45)·k;
resulting in the following general chemical formula of the host lattice:
(LuₓY_{y}Gd_{z}AKₖ)₃(Al_{1-c-(7/45)·k}B_{c}P_{k/3})₅O₁₂.

5. Garnet luminophore according to one of claims 1 to 4, **characterized in that** the wildcard symbol AK stands for Li or Na.

6. Garnet luminophore according to claim 2 or claim 5 that refers back to claim 2, **characterized in that** the wildcard symbol X stands for F.

7. Garnet luminophore according to any one of claims 1 to 6, **characterized in that** a mean wavelength of the second wavelength range is between 500 nm and 600 nm.

8. Method for producing a garnet luminophore, comprising the following steps:
- Providing at least one compound including Lu, Y, and/or Gd and at least one compound including Al, Ga, and/or In, wherein at least one of the compounds is made up of an oxide;
- Providing a compound including Ce;
- Providing a compound of the general chemical formula AKX, wherein AK stands for one or several alkaline metals selected from the group including the elements Li, Na, and K, and X stands for a halogen selected from the group including the elements F, Cl, and Br;
- Grinding and mixing of the chemical compounds provided into a mixture;
- Heating of the mixture to a temperature of more than 1,400°C, whereby the mixture reacts to form a garnet luminophore; and
- Cooling of the garnet luminophore.

9. Light source with a garnet luminophore according to any one of claims 1 to 7 and with a radiation source for emitting an electromagnetic radiation in a first wavelength range.

10. Light source according to claim 9, **characterized in that** the second wavelength range of the garnet luminophore has a maximum in the green spectral region of the light spectrum, and **in that** the light source includes a second conversion luminophore which can be excited by the radiation that can be emitted from the radiation source, whereby the second conversion luminophore can emit electromagnetic radiation in the orange and/or red spectral regions of the light spectrum.

11. Light source according to claim 9 or 10, **characterized in that** said light source is formed by a LED or by a LED backlight for a liquid crystal display.

## Revendications

1. Substance luminescente au grenat, laquelle par un rayonnement électromagnétique est excitable dans une première gamme de longueurs d'ondes, suite à quoi un rayonnement électromagnétique est émissible dans une deuxième gamme de longueurs d'ondes de la substance luminescente au grenat, la substance luminescente au grenat étant activée avec du Cer trivalent et comportant un réseau hôte de la formule chimique générale suivante :
(LuₓY_{y}Gd_{z}AKₖ)₃(Al_{b}B_{c}P_{d})₅(OₑX_{f})₁₂
avec :
AK = un ou plusieurs métaux alcalins, choisi (s) dans le groupe comprenant les éléments : Li, Na et K :
B = Ga et/ou In ;
X = un ou plusieurs halogènes, choisis dans le groupe comprenant les éléments F, Cl et Br ;
• 0 ≤ x, y, z < 1 ;
• x + y + z + k = 1 ;
• 0 < k < 1 ;
• 0 ≤ b ≤ 1 ;
• 0 ≤ c ≤ 1 ;
• 0 < b + c ;
• 0 ≤ d < 1 ;
• b + c + d ≤ 1 ;
• 0 < e ≤ 1 ;
• 0 < f < 1 ; et
• e + f ≤ 1.

2. Substance luminescente au grenat selon la revendication 1, **caractérisée en ce que**
• d = 0 ;
• b + c = 1 ;
• f = k/4 ; et
• e = 1 - (3/8).k ;
résultant dans la formule chimique générale suivante du réseau hôte
(LuₓY_{y}Gd_{z}AKₖ)₃(Al_{b}B_{1-b})₅(O_{1-(3/8)·k}X_{k/4})₁₂.

3. Substance luminescente au grenat, laquelle par un rayonnement électromagnétique est excitable dans une première gamme de longueurs d'ondes, suite à quoi un rayonnement électromagnétique est émissible dans une deuxième gamme de longueurs d'ondes de la substance luminescente au grenat, la substance luminescente au grenat étant activée avec du Cer trivalent et comportant un réseau hôte de la formule chimique générale suivante :
(LuₓY_{y}Gd_{z}AKₖ)₃(Al_{b}B_{c}P_{d})₅(OₑX_{f})₁₂
avec :
AK = un ou plusieurs métaux alcalins, choisi(s) dans le groupe comprenant les éléments : Li, Na et K :
B = Ga et/ou In ;
X = un ou plusieurs halogènes, choisis dans le groupe comprenant les éléments F, Cl et Br ;
• 0 ≤ x , y , z < 1 ;
• x + y + z + k = 1 ;
• 0 < k < 1 ;
• 0 ≤ b ≤ 1 ;
• 0 ≤ c ≤ 1 ;
• 0 < b + c ;
• 0 ≤ d < 1 ;
• b + c + d ≤ 1;
• 0 < e ≤ 1 ;
• 0 < f < 1 ; et
• e + f ≤ 1.

4. Substance luminescente au grenat selon la revendication 3, **caractérisée en ce que**
• e = 1 ;
• f = 0
• d = k/3 ; et
• b = 1 - c - (7/45) . k ;
résultant dans la formule chimique générale suivante du réseau hôte
(LuₓY_{y}Gd_{z}AKₖ)₃(Al_{1-c-(7/45)·k}B_{c}P_{k/3})₅O₁₂.

5. Substance luminescente au grenat selon l'une quelconque des revendications 1 à 4, **caractérisée en ce que** le substitut AK est placé pour Li ou pour Na ;

6. Substance luminescente au grenat selon la revendication 2 ou la revendication 5, se référant à la revendication 2, **caractérisée en ce que** le substitut X est placé pour F.

7. Substance luminescente au grenat selon l'une quelconque des revendications 1 à 6, **caractérisée en ce qu'**une longueur d'ondes moyenne de la deuxième gamme de longueurs d'ondes est comprise entre 500 nm et 600 nm.

8. Procédé de fabrication d'une substance luminescente au grenat comprenant les étapes suivantes :
- de la mise à disposition d'au moins un composé comprenant du Lu, de l'Y et/ou du Gd et d'au moins un composé comprenant de l'Al, du Ga et/ou de l'In, au moins l'un des composés étant formé par un oxyde ;
- de la mise à disposition d'un composé comprenant du Ce ;
- de la mise à disposition d'un composé de la formule chimique générale AKX, AK étant placé pour un ou plusieurs métaux alcalins, choisis dans le groupe comprenant les éléments Li, Na et K et X étant placé pou un halogène choisi dans le groupe comprenant les éléments F, Cl et Br ou pour un phosphate ;
- du broyage et du mélange des composés chimiques mis à disposition en un mélange ;
- de l'échauffement du mélange à une température supérieure à 1.400 °C, suite à quoi, le mélange réagit en une substance luminescente au grenat ; et
- du refroidissement de la substance luminescente au grenat.

9. Source luminescente avec un substance luminescente au grenat selon l'une quelconque des revendications 1 à 7 et avec une source de rayonnement destinée à émettre un rayonnement électromagnétique dans la première gamme de longueurs d'ondes.

10. Source luminescente selon la revendication 9, **caractérisée en ce que** la deuxième gamme de longueurs d'ondes de la substance luminescente au grenat comporte un maximum dans le domaine spectral vert et **en ce que** la source lumineuse comprend une deuxième substance luminescente de conversion qui est excitable par le rayonnement émissible par la source de rayonnement, suite à quoi un rayonnement électromagnétique dans le domaine spectral orange et/ou rouge du spectre lumineux de la deuxième substance luminescente de conversion est émissible.

11. Source lumineuse selon la revendication 9 ou la revendication 10, **caractérisée en ce qu'**elle est formée par un éclairage d'arrière-plan à LED pour un affichage aux cristaux liquides.
